# EUROPÄISCHE PATENTANMELDUNG

(11) **EP 1 205 975 A2**
(43) Veröffentlichungstag der Anmeldung: **15.05.2002**
(21) Anmeldenummer: 01123517.3
(22) Anmeldetag: 29.09.2001
(51) Int. Cl.: H01L 23/525

(54) **Abgleichelement für integrierte Halbleiterschaltungen**

(30) Priorität: 14.11.2000 DE 10056411
(71) Anmelder: ELMOS Semiconductor AG, 44227 Dortmund (DE)
(72) Erfinder: Rost, Wolfgang, 44137 Dortmund (DE)
(74) Vertreter: Hilleringmann, Jochen, Dipl.-Ing.

(57) **Zusammenfassung**

Das Abgleichelement für integrierte Halbleiterschaltungen, das irreversibel von einem niederohmigen in einen hochohmigen Zustand überführbar ist, ist versehen mit einem Halbleitersubstrat (10), einem in dem Halbleitersubstrat (10) integriertem Bauelement (24,28), das bei Durchfluss von elektrischem Strom zumindest in einem Teilbereich vermehrt Wärme erzeugt, und einer in mindestens einem Teilabschnitt (22) schmelzbaren Leiterbahn (18), die elektrisch mit dem Bauelement (24,28) in Reihe geschaltet ist. Der mindestens eine Schmelzabschnitt (22) der Leiterbahn (18) ist mit dem mindestens einen Wärmeerzeugungsbereich des Bauelements (24,28) derart thermisch gekoppelt ist, dass die in dem mindestens einen Wärmeerzeugungsbereich des Bauelements (24,28) erzeugte Wärme zum Schmelzen des mindestens einen Schmelzabschnitts (22) führt.

## Beschreibung

Die Erfindung betrifft ein Abgleichelement für integrierte Halbleiterschaltungen, das irreversibel von einem niederohmigen in einen hochohmigen Zustand überführbar ist.

Wenn die geforderte Präzision der Funktionen von integrierten Halbleiterschaltungen wegen stets vorhandener Fertigungstoleranzen nicht ausreichend sichergestellt werden kann, ist es erforderlich, eine solche integrierte Halbleiterschaltung nach ihrer Fertigstellung mittels vorzugsweise integrierter Abgleichelemente abzugleichen. Z.B. kann mit derartigen Abgleichelementen eine Referenzspannung oder eine Oszillatorfrequenz sehr nahe auf ihren Sollwert eingestellt werden.

Abgleichelemente arbeiten grundsätzlich gemäß zweier unterschiedlicher Verfahren. So können mit Abgleichelementen Strompfade gezielt irreversibel von einem hochohmigen Zustand in einen niederohmigen oder von einem niederohmigen Zustand in einen hochohmigen überführt werden. Ein Abgleichelement des erstgenannten Typs ist z.B. eine Zapping-Diode, bekannt z.B. aus der DE 197 23 747 C1, während zum Abgleichelement des zweitgenannten Typs eine sogenannte Fuse, d.h. schmelzbare Leiterbahn zu zählen ist, vgl. hierzu z.B. die EP 1 032 040 A2). Eine Fuse ist zwar als schmaler durch Schmelzen zu unterbrechender Strompfad wesentlich einfacher aufgebaut und damit einfacher herstellbar als eine Zapping-Diode, hat aber den Nachteil, wegen der im Ausgangszustand gegebenen Niederohmigkeit des Strompfades nur eine geringe Verlustleistung erzeugen zu können. Deshalb sind vergleichsweise hohe Stromimpulse für einen Abgleichvorgang erforderlich, was wiederum stets Probleme bezüglich der Zuverlässigkeit und Langlebigkeit der Messspitzen bedeutet, über die der Stromimpuls in das Abgleichelement und die integrierte Halbleiterschaltung gelangt. Darüber hinaus ist in einem herkömmlichen Fuse-Abgleichelement wegen der geringen am Abgleichvorgang beteiligten Materialmasse nur eine kleine Wärmemenge gespeichert, wodurch ein zeitliches Fortwirken des Schmelzvorganges nach erfolgter Stromunterbrechung nicht möglich ist und sich ein Abgleichvorgang entweder sofort oder erst nach längerer Zeit des Einsatzes im Feld als nicht positiv abgelaufen erweist. Diese möglichen Effekte stellen ein Kostenproblem sowie ein ernstes Zuverlässigkeits- und Sicherheitsrisiko dar.

Der Erfindung liegt die Aufgabe zu Grunde, ein irreversibel von einem niederohmigen in einen hochohmigen Zustand überführbares Abgleichelement für integrierte Schaltungen anzugeben, dessen Funktions- und Arbeitsweise zuverlässig und reproduzierbar ist.

Zur Lösung dieser Aufgabe wird mit der Erfindung ein Abgleichelement für integrierte Halbleiterschaltungen vorgeschlagen, das versehen ist mit:
- einem Halbleitersubstrat,
- einem in dem Halbleitersubstrat integriertem Bauelement, das bei Durchfluss von elektrischem Strom zumindest in einem Teilbereich vermehrt Wärme erzeugt, und
- einer in mindestens einem Teilabschnitt schmelzbaren Leiterbahn, die elektrisch mit dem Bauelement in Reihe geschaltet ist, wobei der mindestens eine Schmelzabschnitt der Leiterbahn mit dem mindestens einen Wärmeerzeugungsbereich des Bauelements thermisch eng gekoppelt ist, so dass die in dem mindestens einen Wärmerzeugungsbereich des Bauelements erzeugte Wärme zum Schmelzen des mindestens einen Schmelzabschnittes führt.

Das erfindungsgemäße Abgleichelement weist die eigentliche Schmelzbahn (schmelzbarer Abschnitt einer Leiterbahn) und ein insbesondere auf Grund der Anordnung in räumlicher (unmittelbarer) Nähe thermisch gut mit der Schmelzbahn gekoppeltes passives oder aktives Bauelement auf, wie z.B. eine pn-Diode, einen Transistor oder einen Widerstand. Diese beiden Komponenten des Abgleichelements sind elektrisch in Serie geschaltet. Das die Wärme erzeugende Bauelement wird vor allem für den Abgleichvorgang so benutzt, dass es in der Lage ist, während des Abgleichvorganges eine hohe Leistung in Form von Wärme freizusetzen.

In den Unteransprüchen sind diverse Ausgestaltungen der Erfindung angegeben.

So ist es z.B. für die thermische Ankopplung der Schmelzbahn an das wärmeerzeugende Bauelement von Vorteil, wenn die Schmelzbahn unmittelbar über dem (mindestens einen) Wärmeerzeugungsbereich des Bauelements verläuft und nur durch eine sehr dünne Isolationsschicht von diesem getrennt ist.

Zur Verbesserung des Wärmetransports durch die Isolationsschicht zur Schmelzbahn bietet es sich an, einen Teil dieser Isolationsschicht durch eine Polysiliziumschicht zu ersetzen, die eine größere thermische Leitfähigkeit als z.B. Siliziumoxid aufweist, was bei integrierten Schaltungen im Regelfall als elektrischer Isolator (Dielektrikum) Verwendung findet.

Bei der Schmelzbahn handelt es sich um ein Metall und insbesondere um Aluminium. Ab Temperaturen von etwa 450°C treten zwischen Aluminium und Polysilizium metallurgische Legierungsprozesse (Eutektikum-Bildung) auf, die an sich in Halbleiterschaltungen unerwünscht sein können. Für die Bildung des Eutektikums der Legierung aus Aluminium und Polysilizium kommt es nämlich zu einer "Wanderung" von Aluminium in das Polysilizium und damit zu einem "Materialtransport", der die Aluminium-Leiterbahnen schwächt. Daher und wegen der Gefahr zur Bildung von Kurzschlüssen an pn-Übergängen, in deren unmittelbaren Kontaktbereich wird in heutigen Metallisierungstechnologien in den Kontaktbereichen der Aluminiumschicht mit Polysiliziumgebieten der Halbleiterschaltung eine Barriereschicht aufgebracht, die die obigen Materialwechselwirkungen unterbindet.

Für das erfindungsgemäße Abgleichelement mit Polysiliziumbereichen zwischen der Schmelzbahn und dem Wärmeerzeugungsbereich des integrierten Bauelements sind die obigen Wechselwirkungen dagegen erwünscht, da sie die gewollte Zerstörung der Schmelzbahn unterstützen. Daher lässt sich das Abgleichelement gemäß der hier beschriebenen Ausgestaltung insbesondere unter Verwendung von Metallisierungstechnologien ohne Barriereschichten herstellen, bei denen Aluminium direkt Polysiliziumgebiete kontaktiert.

Bei Verwendung von Barriereschichten unter der Metallisierungsschicht könnte man durch einen entsprechenden Ausmaskierungsvorgang dafür sorgen, dass das Barrierematerial nicht auf diejenigen Polysiliziumgebiete aufgebracht wird, die von Schmelzbahnen kontaktiert werden sollen. Allerdings erhöht dieser Ausmaskierungsvorgang den Herstellungsaufwand der gesamten durch die erfindungsgemäßen Abgleichelemente abgleichbaren Halbleiterschaltung.

Die metallurgische Materialwechselwirkung zwischen Aluminium und Polysilizium kann für das erfindungsgemäße Konzept aber auch bei Verwendung einer Metallisierungstechnologie mit Barriereschicht ohne Ausmaskierungsvorgang ausgenutzt werden, wenn, wie in einer weiteren Ausgestaltung der Erfindung vorgesehen, die Kontaktfenster in der unterhalb der Aluminiumschicht vorhandenen Isolationsschicht (Oxid) nicht vollständig mit Aluminium ausgefüllt werden, so dass zum Rand hin, zumindest bereichsweise, ein freier Zwischenraum verbleibt, der letztendlich dadurch entsteht, dass das Kontaktfenster größer als die darüber verlaufende Schmelzbahn gestaltet wird. Über diesen Freiraum kann es nun zu den für die gewollte Zerstörung der Schmelzbahn vorteilhaften metallurgischen Materialwechselwirkungen zwischen Aluminium und Polysilizium kommen.

Mit der Erfindung wird also ein Abgleichelement geschaffen, das sich leicht herstellen lässt, da außer den z.B. in CMOS-Technologien üblichen minimal benötigten Prozessschritten keine zusätzlichen Prozessschritte erforderlich sind. Das erfindungsgemäße Abgleichelement ermöglicht zuverlässige Abgleichvorgänge bei moderaten Strömen und Spannungen.

Die Erfindung wird nachfolgend anhand mehrerer Ausgestaltungsbeispiele unter Bezugnahme auf die Zeichnungen näher erläutert. Im einzelnen zeigen:
- Fig. 1: ein erstes Ausführungsbeispiel des Abgleichelements für integrierte Halbleiterschaltungen mit einer pn-Diode als aktives wärmeerzeugendes Bau-(Schaltungs-)element in Draufsicht,
- Fig. 2: einen Schnitt entlang der Linie II-II der Fig. 1,
- Fig. 3: eine Schaltungssymboldarstellung des Abgleichelements nach Fign. 1 und 2
- Fig. 4: ein zweites Ausführungsbeispiel des Abgleichelements mit einer pn-Diode als aktives wärmeerzeugendes Bau- bzw. Schaltungselement mit verbesserter thermischer Ankopplung,
- Fig. 5: einen Schnitt entlang der Linie V-V von Fig. 4,
- Fig. 6: eine Schaltungssymboldarstellung des Abgleichelements nach Fign. 4 und 5,
- Fig. 7: ein drittes Ausführungsbeispiel eines Abgleichelements für integrierte Halbleiterschaltungen ebenfalls wiederum mit einer pn-Diode,
- Fig.8: einen Schnitt entlang der Linie VIII-VIII der Fig. 7,
- Fig. 9: eine Schaltungssymboldarstellung des Abgleichelements nach Fign. 7 und 8,
- Fig. 10: ein viertes Ausführungsbeispiel eines Abgleichelements für integrierte Halbleiterschaltungen ebenfalls wiederum mit einer pn-Diode,
- Fig. 11: einen Schnitt entlang der Linie XI-XI der Fig. 10,
- Fig. 12: eine Schaltungssymboldarstellung des Abgleichelements nach Fign. 10 und 11,
- Fig.13: ein fünftes Ausführungsbeispiel eines Abgleichelements für integrierte Halbleiterschaltungen mit einem Transistor als wärmeerzeugendes Bau- bzw. Schaltungselement,
- Fig. 14: einen Schnitt entlang der Linie XIV-XIV der Fig. 13,
- Fig. 15: eine Schaltungssymboldarstellung des Abgleichelements nach Fign. 13 und 14,

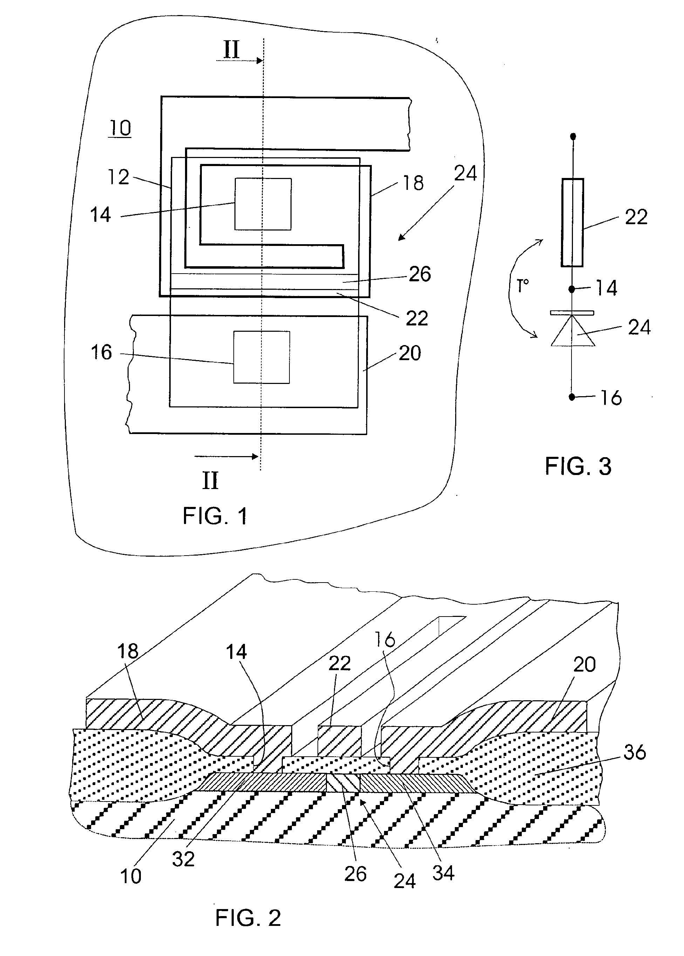

Das erfindungsgemäße Abgleichelement wird nach bekannten Verfahren der Halbleitertechnologie, insbesondere für CMOS-Schaltungen, wie fototechnische Maskierungen, thermische Behandlungen zur Oxidation und Diffusion, diverse Schichtabscheidungen, Ätzschritte und Dotierschritte hergestellt, indem in einem Silizium-Substrat 10 ein mit einer dünnen dielektrischen Schicht bedecktes sogenanntes Aktivgebiet 12 erzeugt wird, das die aktive Schaltungsstruktur aufnimmt, und mit entsprechenden Anschlussöffnungen 14,16 zur Kontaktierung des aktiven Schaltungs- bzw. Bauelements versehen ist (siehe Fign. 1,2;4,5;7,8;10,11;13;14).

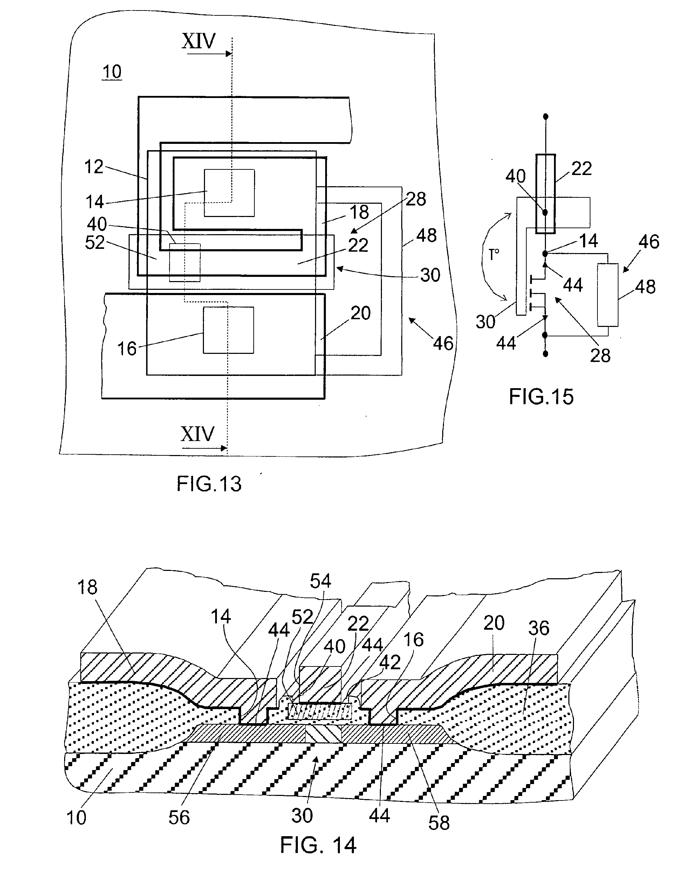

Die Anschlussöffnungen 14,16 werden mittels strukturierter Metallbahnen 18,20, welche üblicherweise aus Aluminium oder Aluminiumlegierungen bestehen, mit anderen Schaltungsteilen verbunden, wobei beim erfindungsgemäßen Abgleichelement die von der Anschlussöffnung 14 aus verlaufende Metallbahn 18 einen schmalen Streifen 22 (Schmelzbahn) unmittelbar über der aktiven Zone des Bauelements aufweist. Im Falle einer pn-Diode 24 verläuft also die Schmelzbahn 22 über dem pn-Übergang 26 (siehe Fign. 1,2;4,5;7,8;10;11), während sie im Falle eines Transistors 28 über dessen Kanalgebiet 30 verläuft (siehe Fign. 13,14). Im Ergebnis erhält man das erfindungsgemäße Abgleichelement bestehend aus der eigentlichen Schmelzbahn 22 und einem räumlich bei ihm gelegenen, die thermische Energie zum Schmelzen der Schmelzbahn 22 erzeugenden (aktiven) Schaltungselements (pn-Diode 24 oder Transistor 28), die beide elektrisch in Serie geschaltet sind.

In den Fign. 1 und 2 ist das erfindungsgemäße Abgleichelement mit einer pn-Diode 24 als aktive Schaltungsstruktur in seiner allgemeinen wesentlichen Art dargestellt. Fig. 3 zeigt eine symbolische Darstellung dieses Abgleichelements. Der sich im Übergangsgebiet von vorzugsweise hochdotierten n- und p-leitenden Bereichen 32,34 innerhalb des Aktivgebietes 12 ausbildende pn-Übergang 26 ist die aktive Zone der pn-Diode 24. Die Anschlussöffnungen 14,16 befinden sich innerhalb einer Isolationsschicht 36 (Dielektrikum) aus Siliziumoxid, und zwar innerhalb des relativ dünnen Bereichs über den p- und n-leitenden Bereichen 32,34 der Diode 24, also innerhalb des Aktivgebiets 12. Außerhalb des Aktivgebiets 12 ist die Isolationsschicht 36 deutlich dicker als innerhalb. In den Fign. 1 und 2 ist die Metallbahn 18 von der Kathodenanschlussöffnung 14 kommend als schmale Schmelzbahn 22 unmittelbar über den pn-Übergang 26, d.h. über die aktive Zone der pn-Diode 24, geführt. Wegen der verwendeten Serienschaltung von pn-Diode 24 und Schmelzbahn 22 ist es selbstverständlich egal, mit welcher der beiden Diodenanschlussöffnungen die Schmelzbahn 22 unmittelbar verbunden ist.

Fließt durch diese Struktur ein Strom, der über dem pn-Übergang 26 der pn-Diode 24 eine vergleichsweise hohe Potentialdifferenz erzeugt, so wird beim Überschreiten eines kritischen Wertes der in dem pn-Übergang 26 in Wärme umgesetzten Leistung die Schmelzbahn 22 aufgeschmolzen, der Stromfluss unterbrochen und das Abgleichelement irreversibel hochohmig.

Durch thermisches Überschwingen und durch die Wärmekapazität des Teils des Siliziumsubstrates 10, der den pn-Übergang 26 der pn-Diode 24 enthält, wird Wärme von dort noch weiter nachgeliefert und die hohe Temperatur im Bereich der Schmelzbahn 22 des Abgleichelements noch kurzzeitig beibehalten und somit das Erreichen des gewünschten hochohmigen Endzustandes reproduzierbarer und sicherer.

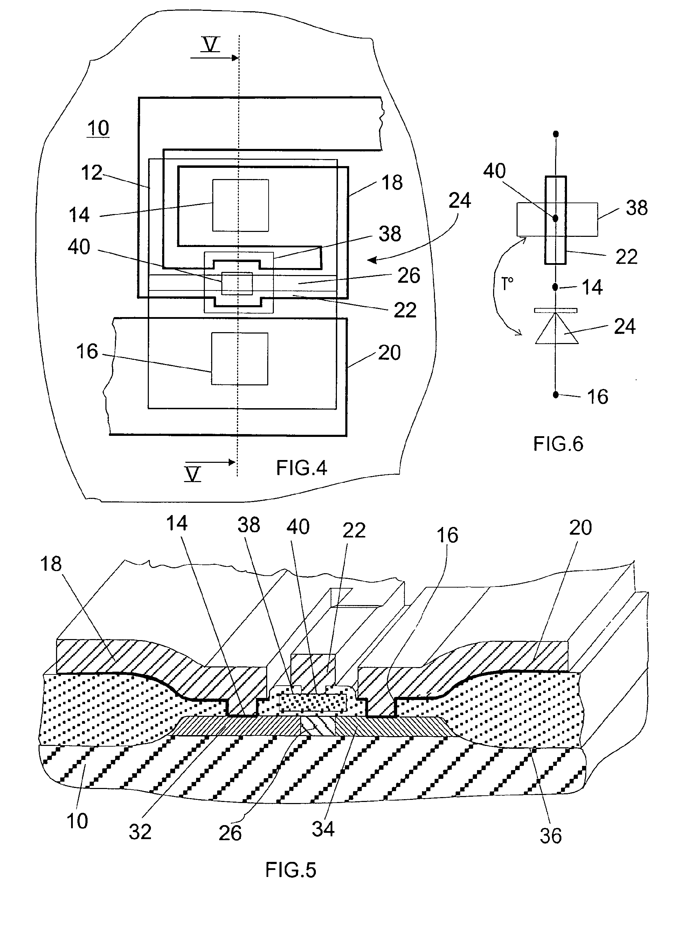

Diese Eigenschaft des Abgleichelements kann noch weiter verbessert werden, wenn, wie in den Fign. 4 und 5 gezeigt, welche eine Weiterentwicklung des zuvor beschriebenen Abgleichelements wiedergeben, ein Polysiliziumbereich 38 zwischen dem pn-Übergang 26 der Diode 24 und der Schmelzbahn 22 angeordnet wird, wobei der Polysiliziumbereich 38 mit der Schmelzbahn 22 über eine Kontaktierungsöffnung 40 kontaktiert und durch den Teil der Isolationsschicht 36, der unter dem Polysilizium liegt, gegenüber dem pn-Übergang 26 isoliert ist. Dieser unter dem Polysilizium innerhalb des Aktivgebietes 12 liegende Teil der Isolationsschicht 36 ist vielfach dünner als das Oxid unter der Schmelzbahn entsprechend dem ersten Ausführungsbeispiel (Fign. 1 bis 3). Die zugehörige symbolische Darstellung dieses Elements ist in Fig. 6 angegeben. Dadurch wird eine bessere thermische Kopplung zwischen der Schmelzbahn 22 und dem darunter im Siliziumsubstrat 10 in der Nähe befindlichen pn-Übergang 26 der pn-Diode 24 erreicht. Die Polysiliziumschichten in einer integrierten CMOS-Halbleiterschaltung liegen nämlich immer näher am Silizium-substrat 10 als die Metallbahnen 18,20. Der in diesem Falle (verglichen mit der zuvor beschriebenen allgemeinen Art des Abgleichelements) zusätzlich vorhandene Polysiliziumbereich 38 bewirkt auch eine bessere thermische Kopplung, da dieses Material ein sehr guter thermischer Leiter ist. Äußerst vorteilhaft ist es auch, den Polysiliziumbereich 38 so zu platzieren, dass sich zwischen ihm und dem Siliziumsubstrat 10 möglichst nur das dünne Dielektrikum (dünner Bereich der Isolationsschicht 36) aktiver Schaltungsstrukturen, wie Transistoren und Dioden der integrierten Halbleiterschaltungen befinden.

Ein weiterer, positiv auf den Vorgang der Unterbrechung (Zerstörung) der Schmelzbahn 22 wirkender Effekt ist der, dass bei Temperaturen oberhalb von etwa 450°C Legierungsprozesse zwischen Aluminium und Silizium (Poly-Silizium) einsetzen. Das bedeutet, dass das Metall der heißen Schmelzbahn 22 über die Kontaktierungsöffnung 40 von dem Polysiliziumbereich 38 "aufgesaugt" wird. Dieses einem Schwamm vergleichbare Verhalten ist sehr willkommen, da es einen Transport von Material von der Schmelzbahn 22 weg in den Polysiliziumbereich 38 hinein bewirkt, was eine zuverlässige Unterbrechung der Schmelzbahn 22 unterstützt.

Im Falle der Anwendung moderner Metallisierungstechnologien sind Metallkontaktbereiche zum Siliziumsubstrat und zu Polysiliziumbereichen einer Halbleiterschaltungsstruktur oft mit Barrieren ausgestattet, die Materialwechselwirkungen, wie die oben beschriebene Legierung, erschweren oder unmöglich machen sollen. Das würde natürlich auch den mit einem saugenden Schwamm vergleichbaren Wechselwirkungseffekt zwischen Silizium und dem eigentlichen Leitbahnmetall weitgehend unterbinden.

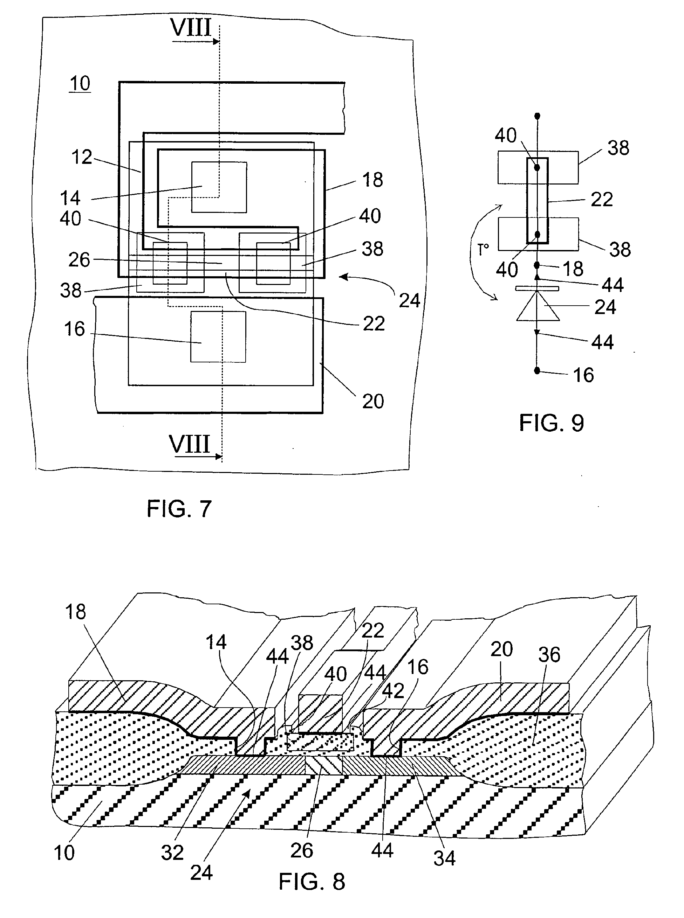

Entgegentreten kann man dieser Barrierenwirkung, ohne die Barriere mittels eines Fototechnik- und Ätzschrittes aufwendig an den betreffenden Stellen zu entfernen, auf einfache Weise dadurch, dass man, wie in den Fign. 7 und 8 gezeigt, die Kontaktierungsöffnung 40 zwischen dem Polysiliziumbereich 38 und der Schmelzbahn 22, entgegen sonst üblichen Regeln, größer ausführt als die Schmelzbahn 22 breit ist, so dass diese die Kontaktierungsöffnung 40 nicht vollständig überdeckt und somit ein oder mehrere Zwischenräume bzw. Nuten 42 zum Rand der Kontaktierungsöffnung 40 frei bleiben. Global wird dadurch die Barrierenwirkung erhalten (siehe die Barriereschicht 44 unterhalb der Metallbahnen 18,20), an Kontaktstellen, die wie zuvor beschrieben konstruiert sind, jedoch deutlich herabgesetzt. Grund dafür ist, dass die Barrierewirkung an der Ätzkante der Metallbahn (Schmelzbahn 22) in seitliche Richtung in der vergrößerten Kontaktöffnung wegen des Zwischenraumes 42 nicht mehr existiert und an ein Dielektrikum grenzt, mit dem die integrierte Schaltung nach der Strukturierung der Metallbahnen (inkl. der Schmelzbahn 22 des Abgleichelements) durch eine entsprechende Schichtabscheidung bedeckt wird. Diese Materialkombination erweist sich bei hohen Temperaturen als reaktiv und in der Lage, den geringen Abstand zwischen dem eigentlichen Material der Schmelzbahn 22 und dem Polysiliziumbereich 38, der der Dicke der Barriereschicht 44 von ca. 100 nm entspricht, zu überwinden und den oben beschriebenen mit einem saugenden Schwamm vergleichbaren Effekt an diesen Stellen trotzdem wirksam werden lässt. Die symbolische Darstellung dieser Ausführung des erfindungsgemäßen Abgleichelements ist in Fig. 9 zu sehen. Die Pfeile auf den Leitungen deuten die Barriereschicht 44 an.

In Fig. 7 ist auch gezeigt, dass mehrere Polysiliziumbereiche 38 in einem Abgleichelement verwendet werden können. Allgemein ist eine symmetrische oder unsymmetrische Anordnung der Polysiliziumbereiche 38 möglich.

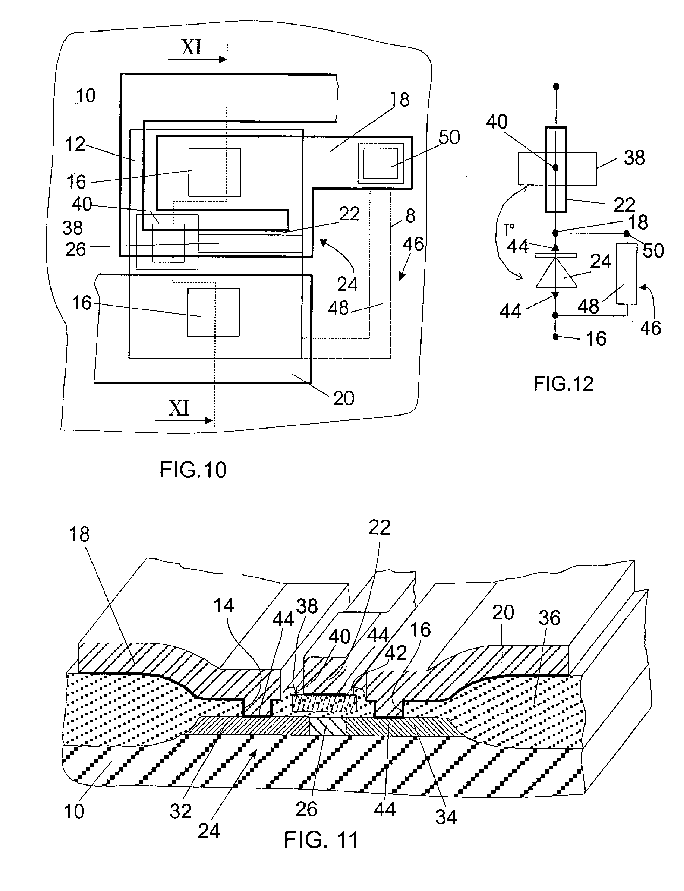

Bei der Verwendung des Abgleichelements kann es vorkommen, dass bedingt durch seine konkrete Geometrie oder eine begünstigende Verteilung der Dotierstoffe in der pn-Diode 24 ein den ursprünglichen Zustand des Abgleichelements charakterisierender Arbeitspunkt (kleiner Spannungsabfall) nur einstellbar ist, wenn sehr kleine Ströme im pA-Bereich eingespeist werden. Das ist aber reproduzierbar kaum möglich. Deshalb wird in einer weiteren Ausführungsform des Abgleichelements, die in den Fign. 10, 11 und 12 zu sehen ist, parallel zur pn-Diode 24 ein Widerstand 46 gelegt, der einerseits den Arbeitspunkt des ursprünglichen Zustandes des Abgleichelements sicher und reproduzierbar im nA- bis µA-Bereich einzustellen erlaubt und andererseits während des Abgleichvorganges keinen nennenswerten Strom an der pn-Diode 24 vorbei leitet. Selbiges gilt auch dann, wenn anstelle der pn-Diode 24 ein Transistor 28 als aktives Bauelement verwendet wird.

Der parallel zur pn-Diode 24 liegende Widerstand 46 ist gemäß Fig. 10 so ausgeführt, dass er wegen des gleichen Leitungstyps seiner Widerstandsbahn 48 wie die Anode mit dieser unmittelbar verbunden ist, wobei die Widerstandsbahn 48 am anderen Ende eine Kontaktierungsöffnung 50 besitzt und auf diese Weise über die zur Kontaktierungsöffnung 50 geführte Metallbahn 18 mit der Kathode (n-Gebiet 32) der Diode 24 verbunden ist.

Nach erfolgtem Abgleichvorgang spielt dieser Widerstand ebenso wenig eine Rolle wie die pn-Diode 24 selbst, weil die Schmelzbahn 22 unterbrochen und das Abgleichelement dauerhaft hochohmig ist. Über den Wert des parallel liegenden Widerstandes 46 lässt sich der Arbeitspunkt in weiten Grenzen leicht an die Schaltungserfordernisse anpassen. Insbesondere kann einfach auf die permanente Verlustleistung des Abgleichelement in seinem ursprünglichen Zustand eingewirkt werden. Fig. 12 zeigt das erfindungsgemäße Abgleichelement mit parallel liegendem Widerstand in symbolischer Darstellung.

Einen Feldeffekttransistor 28 mit isoliertem Gate 52 als in Serie zur Schmelzbahn 22 liegendes aktives Bauelement zur Erzeugung der zum Schmelzen der Schmelzbahn 22 erforderlichen thermischen Energie verwendet das Abgleichelement in den Fign. 13 bis 15. Dabei sind in den Fign. 13 bis 15 für die Einzelteile die gleichen Bezugszeichen wie in den anderen Fign. verwendet, sofern die betreffenden Einzelteile des Transistors denen der Ausführungen mit Dioden entsprechen. Das aus Polysilizium bestehende Gate 52 und die Schmelzbahn 22 sind an einer Stelle über eine Kontaktierungsöffnung 54 unmittelbar miteinander verbunden. Die Schmelzbahn 22 wird vom Drain-Gebiet 56 kommend über den Kanalbereich 30, d.h. die aktive Zone des Feldeffekttransistors 28, geführt. Symbolisch ist diese Ausführung des erfindungsgemäßen Abgleichelements in Fig. 15 zu sehen. Seine Funktion ist im wesentlichen analog zu der des Abgleichelements mit pn-Diode. Der physikalische Mechanismus der Erzeugung der für den Schmelzvorgang erforderlichen Verlustleistung unterscheidet sich von dem einer pn-Diode, was aber für das Abgleichelement selbst ohne Bedeutung ist. Der nicht unbedingt erforderliche, aber in Fig. 13 gezeigte, parallel zum Feldeffekttransistor geschaltete Widerstand 46 verbessert auch hier die Einstellbarkeit eines Arbeitspunktes des Abgleichelements im ursprünglichen Zustand mit kleinem Spannungsabfall.

Der parallel zum Feldeffekttransistor 28 liegende Widerstand 46 kann, wenn er vom gleichen Leitungstyp wie die Drain- und Source-Gebiete 56,58 des Transistors 28 ist, ohne einen speziellen Kontakt direkt mit diesen verbunden sein.

## Patentansprüche

1. Abgleichelement für integrierte Halbleiterschaltungen, das irreversibel von einem niederohmigen in einen hochohmigen Zustand überführbar ist, mit
- einem Halbleitersubstrat (10),
- einem in dem Halbleitersubstrat (10) integriertem Bauelement (24,28), das bei Durchfluss von elektrischem Strom zumindest in einem Teilbereich Wärme erzeugt, und
- einer in mindestens einem Teilabschnitt (22) schmelzbaren Leiterbahn (18), die elektrisch mit dem Bauelement (24,28) in Reihe geschaltet ist,
- wobei der mindestens eine Schmelzabschnitt (22) der Leiterbahn (18) mit dem mindestens einen Wärmeerzeugungsbereich des Bauelements (24,28) thermisch derart gekoppelt ist, dass die in dem mindestens einen Wärmeerzeugungsbereich des Bauelements (24,28) erzeugte Wärme zum Schmelzen des mindestens einen Schmelzabschnitts (22) führt.

2. Abgleichelement nach Anspruch 1, **dadurch gekennzeichnet, dass** der mindestens eine Schmelzabschnitt (22) der Leiterbahn (18) oberhalb des mindestens einen Wärmeerzeugungsbereichs des Schaltungselements (24,28) verläuft und dass zwischen dem mindestens einen Schmelzabschnitt (22) und dem mindestens einen Wärmeerzeugungsbereich eine elektrische Isolationsschicht (36) angeordnet ist.

3. Abgleichelement nach Anspruch 2, **dadurch gekennzeichnet, dass** der mindestens eine Wärmeerzeugungsbereich des Schaltungselements (24,28) und der darüber angeordnete mindestens eine Schmelzabschnitt (22) der Leiterbahn (18) überwiegend oder vollständig innerhalb eines Bereichs angeordnet sind, in dem sich ein Aktivgebiet (12) des Halbleitersubstrats (10) mit verringerter Dickenerstreckung der Isolationsschicht (36) befindet.

4. Abgleichelement nach 2 oder 3, **dadurch gekennzeichnet, dass** zwischen dem mindestens einen Schmelzabschnitt (22) der Leiterbahn (18) und dem mindestens einen Wärmeerzeugungsbereich des Bauelement (24,28) mindestens ein Polysiliziumbereich (38) angeordnet ist, der mit dem mindestens einen Schmelzabschnitt (22) der Leiterbahn (18) mittels einer Kontaktierungsöffnung (40) in der Isolationsschicht (36) elektrisch und thermisch direkt verbunden ist und gegenüber dem mindestens einen Wärmeerzeugungsbereich des Bauelements (24,28) elektrisch isoliert ist.

5. Abgleichelement nach Anspruch 4, **dadurch gekennzeichnet, dass** der mindestens eine Schmelzabschnitt (22) der Leiterbahn (18) innerhalb der unter dem mindestens einen Schmelzabschnitt (22) der Leiterbahn (18) angeordneten Isolationsschicht (36) ausgebildeten von einem umlaufenden Rand begrenzte Kontaktierungsöffnung (40) in Kontakt mit dem Polysiliziumbereich (38) steht.

6. Abgleichelement nach Anspruch 5, **dadurch gekennzeichnet, dass** das Material der Leiterbahn (18) innerhalb der Kontaktierungsöffnung (40) den Polysiliziumbereich (38) vollständig kontaktiert.

7. Abgleichelement nach Anspruch 4, **dadurch gekennzeichnet, dass** an der dem Halbleitersubstrat (10) zugewandten Unterseite der Leiterbahn (18) eine Sperrschicht (44) angeordnet ist, die metallurgische Wechselwirkungen des Materials der Leiterbahn (18) mit dem Material von darunter liegenden Schichten, insbesondere auch mit Polysilizium, verhindert, und dass innerhalb der Kontaktierungsöffnung (40) zwischen dem mindestens einen Schmelzabschnitt (22) der Leiterbahn (18) und mindestens einem Teilabschnitt des Randes der Kontaktierungsöffnung (40) ein freier Zwischenraum (42) angeordnet ist.

8. Abgleichelement nach einem der Ansprüche 1 bis 7, **dadurch gekennzeichnet, dass** das Bauelement eine Diode (24) mit einem pn-Übergangsbereich (26) aufweist, in dem bei Betrieb in Sperrrichtung Wärme erzeugt wird, und dass der mindestens eine Schmelzabschnitt (22) durch eine Isolationsschicht (36) gegenüber dem pn-Übergangsbereich (26) elektrisch isoliert ist und sich quer zur Richtung des Stromflusses durch den pn-Übergangsbereich (26) über diesen erstreckt.

9. Abgleichelement nach einem der Ansprüche 1 bis 7, **dadurch gekennzeichnet, dass** das Bauelement einen Feldeffekttransistor (28) mit einem Drain- und einem Source-Gebiet (56,58) sowie einem zwischen diesen angeordneten Kanalgebiet (30) mit einer Gateelektrode (52) aufweist und dass der mindestens eine Schmelzabschnitt (22) der Leiterbahn (18) quer über das Kanalgebiet (30) und die Gateelektrode (52) verläuft.

10. Abgleichelement nach Anspruch 9, **dadurch gekennzeichnet, dass** die Gateelektrode (52) aus Polysilizium besteht und dass die Leiterbahn (18) innerhalb ihres mindestens einen Schmelzabschnitts (22) die Gateelektrode (52) zumindest an einer Stelle kontaktiert.

11. Abgleichelement nach einem der Ansprüche 8 bis 10, **dadurch gekennzeichnet, dass** zur Veränderung des Arbeitspunktes des Bauelements (24,28) parallel zu diesem ein Widerstand (46) geschaltet ist, der insbesondere in dem Halbleitersubstrat integriert ausgebildet ist.

12. Abgleichelement nach einem der Ansprüche 1 bis 7, **dadurch gekennzeichnet, dass** das Bauelement ein Widerstand ist, der in dem Halbleitersubstrat integriert ausgebildet ist.
